# FASCICULE DE BREVET EUROPEEN

(11) **EP 3 477 721 B1**
(45) Date de publication et mention de la délivrance du brevet: **29.07.2020**
(21) Numéro de dépôt: 18201697.2
(22) Date de dépôt: 22.10.2018
(51) Int. Cl.: H01L 51/42

(54) **DISPOSITIF ÉLECTRONIQUE ORGANIQUE OU HYBRIDE ET SON PROCÉDÉ DE FABRICATION**
ELEKTRONISCHE ODER HYBRIDE VORRICHTUNG UND HERSTELLUNGSVARFAHREN DAZU
ELECTRONIC OR HYBRID DEVICE AND FABRICATION METHOD

(30) Priorité: 26.10.2017 FR 1760100
(43) Date de publication de la demande: 01.05.2019
(73) Titulaire: Commissariat à l'énergie atomique et aux énergies alternatives, 75015 Paris (FR)
(72) Inventeur: LEMAITRE, Noëlla, 73000 CHAMBERY (FR)
(74) Mandataire: Brevalex

(56) Documents cités:
- US-A1- 2017 054 099
- US-A1- 2017 229 518
- YANG HAIFENG ET AL: "Effect of polyelectrolyte interlayer on efficiency and stability of p-i-n perovskite solar cells", SOLAR ENERGY, vol. 139, 31 décembre 2016 (2016-12-31), pages 190-198, XP029809495, ISSN: 0038-092X, DOI: 10.1016/J.SOLENER.2016.09.048

## Description

### DOMAINE TECHNIQUE ET ÉTAT DE LA TECHNIQUE ANTÉRIEURE

L'invention concerne le domaine des dispositifs électroniques organiques tels que les cellules photovoltaïques organiques (OPV), les diodes électroluminescentes organiques (OLED), et les photodétecteurs organiques (OPD), et le domaine des dispositifs électroniques hydrides, et plus particulièrement les dispositifs électroniques organiques ou hybrides à structure NIP.

L'invention concerne également un procédé de réalisation de tels dispositifs électroniques organiques ou hydrides. Le document de Yang Haifen et al., Solar Energy, vol. 139, 31 décembre 2016, p. 190-198 décrit un dispositif électronique organique. Le document US2017/0054099 décrit des dispositifs électroniques.

De nos jours, les rendements de conversion d'une cellule photovoltaïque à simple jonction atteignent 10%. L'amélioration non seulement des rendements de conversion mais aussi de la stabilité des cellules photovoltaïques est primordiale pour pouvoir répondre aux exigences de durée de vie des dispositifs commerciaux et pour élargir les champs d'application de cette technologie, par exemple aux objets nomades, de l'ioT (« internet of things »), au mobilier urbain, ou encore pour de l'intégration en bâtiment...

Pour répondre à ce double défi, les recherches s'orientent notamment vers l'étude des matériaux actifs et des architectures des cellules photovoltaïques organiques et des cellules photovoltaïques hybrides.

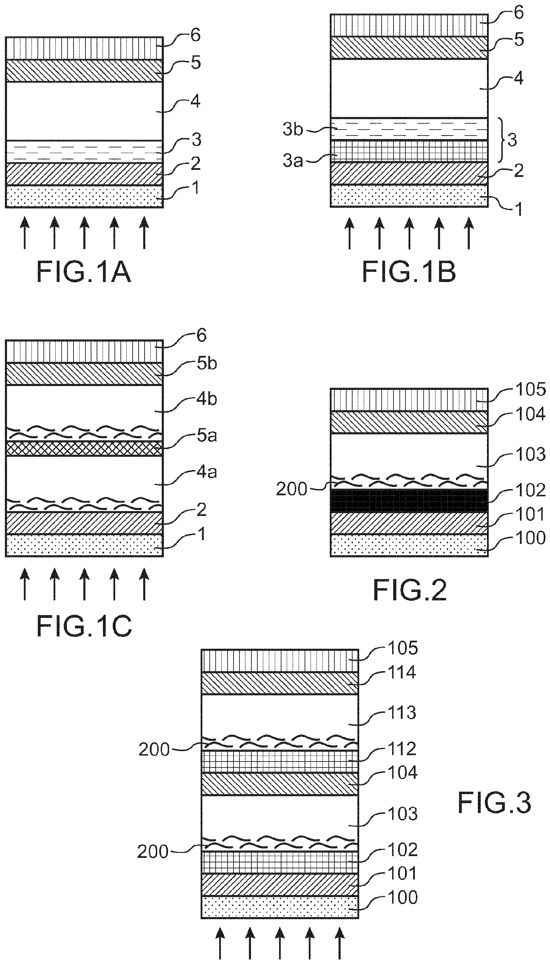

La structure de type inverse (aussi appelée NIP) a été développée dans le but d'améliorer la stabilité de la cellule photovoltaïque organique. Elle est celle qui permet, à ce jour, d'atteindre la durée de vie la plus importante pour ce type de dispositif. Comme représenté sur la figure 1A, la structure de type inverse comprend un substrat 1 sur lequel sont disposés :
- une première électrode 2 (cathode) en un matériau transparent électriquement conducteur, aussi appelée électrode inférieure, classiquement en oxyde d'indium et d'étain (ITO),
- une couche semi-conductrice de type N 3 dite « couche de transport d'électrons » (ou EIL pour « Electron Injection Layer ») ou couche de type N,
- une couche active 4, qui a pour fonction d'absorber les photons et de générer les charges libres, comprenant au moins deux matériaux : un matériau de type N, accepteur d'électrons, et un matériau de type P, donneur d'électrons (transporteur de trous) ; l'hétérojonction en volume de type PN est remplacée par un matériau pérovskite dans le cas d'une cellule photovoltaïque hydride,
- une couche semi-conductrice de type P 5 dite « couche de transport de trous » (ou HTL pour « Hole Transport Layer ») ou couche de type P,
- une seconde électrode 6 (anode) en un matériau électriquement conducteur aussi appelé électrode supérieure.

La couche de type N 3 peut être une monocouche en oxyde métallique, éventuellement dopé, par exemple en ZnO, en ZnO dopé (AZO, ZnO dopé Aluminium) ou en polyéthylènimine (PEI) (figure 1A). Il peut également s'agir d'un bicouche comprenant, par exemple, une couche d'oxyde métallique 3a, telle qu'une couche de ZnO, associée à une couche de PEI 3b (figure 1B).

Par exemple, dans l'article de Jin et al. ("Highly stable and efficcient inverted organic solar cells based on low-temperature solution processed PEIE and ZnO bilayers" J. Mater. Chem. A, 2016, 4, 3784), la couche active en PTB7/PC₇₁BM est déposée sur un bicouche de polyéthylènimine éthoxylé (PEIE) et de ZnO.

Dans l'article de Courtright et al. ("Polyethylenimine Interfacial Layers in Inverted Organic Photovoltaic Devices: Effects of Ethoxylation and Molecular Weight on Efficiency and Temporal Stability" ACS Appl. Mater. Interfaces 2015, 7, 26167) il a été montré que les performances de cellules solaires organiques à base de PBDTTT-FTTE:PC₇₀BM sont améliorées par l'ajout d'un bi-couche ZnO/PEI. L'augmentation de la masse molaire du PEI de 800 à 750000 g.mol⁻¹ conduit à un abaissement du travail de sortie de l'ITO/ZnO et à une augmentation de la stabilité temporelle des dispositifs.

Cependant, comme le PEI est électriquement isolant, il doit être utilisé en très fine couche, typiquement de l'ordre de 5nm, afin de permettre l'extraction des charges tout en limitant les résistances séries. Or, la maîtrise de dépôt nanométrique est souvent critique, ce qui complexifie le procédé de fabrication des cellules. De plus, avec des couches aussi fines, il y a un risque de former une couche non continue, et donc qu'il y ait un contact entre la couche active 4 et la première électrode 2, ce qui diminue la durée de vie des cellules.

Comme représenté sur la figure 1C, une autre solution consiste à incorporer directement le PEI dans la couche active 4a, 4b. Cette approche est, par exemple, décrite dans l'article de Kang et al. ("Simplified Tandem Polymer Solar Cells with an Ideal Self-Organized Recombination Layer" Adv. Mater. 2015, 27, 1408) avec des cellules photovoltaïques à structure tandem simplifiée, comprenant un substrat 1, recouvert par une première électrode 2 en ITO, une première couche active 4a, une couche de type P 5a en PEDOT:PSS, une seconde couche active 4b, une seconde couche de type P 5b en MoOx, une seconde électrode 6. Pour élaborer les couches actives 4a et 4b, une solution dite de PEI contenant de l'eau et un PEI ramifié est diluée à 0,1% massique dans du 2-méthoxyéthanol. Parallèlement, une solution de couche active est préparée en ajoutant du PTB7-Th et du PC₇₀BM (1:1.5) à un mélange de chlorobenzène/1,8-diiodooctane (97 :3 vol%). La solution dite de PEI est ajoutée à la solution de couche active avec un rapport volumique de 10 :90. Le mélange obtenu est ensuite déposé par dépôt à la tournette (« spin-coating »). Il semble que le PEI s'auto-organise dans la couche active vers l'interface ITO/couche active. Les cellules présentent de bons rendements de conversion. Cependant, le procédé nécessite l'utilisation de solvants chlorés, ce qui le rend difficilement industrialisable.

### EXPOSÉ DE L'INVENTION

C'est par conséquent un but de la présente invention de proposer un dispositif électronique organique ou hybride, à structure NIP, présentant une bonne stabilité et ne contenant pas de couche mince de PEI.

Ce but est atteint par un dispositif électronique organique ou hybride, à structure NIP, selon la revendication 1.

La cellule photovoltaïque organique se distingue fondamentalement de l'art antérieur par la présence à la fois de la couche de type N et par la présence de polyéthylèneimine (PEI) dans la couche active.

Les inventeurs ont montré que, même si l'on ajoute le PEI, qui est un matériau électriquement isolant, dans la couche active d'une cellule photovoltaïque comprenant en plus une couche de type N, la cellule photovoltaïque présente un bon rendement et une très bonne stabilité.

Les inventeurs ont montré que la stabilité du dispositif organique selon l'invention est améliorée par rapport à un dispositif ayant une couche de type N sous la forme d'un bicouche ZnO/PEI, ou par rapport à une couche de type N formée d'un mélange ZnO et PEI.

Par transparent, on entend que le substrat et la première électrode ont une transmittance supérieure à 70% dans le domaine visible, i.e. de 350nm à 750nm, et de préférence supérieure à 90% dans le domaine visible.

Avantageusement, le polyéthylèneimine représente de 0,005% à 0,5%, et de préférence de 0,01% à 0,1% massique par rapport au matériau donneur d'électrons ou par rapport au matériau pérovskite de la couche active. De tels pourcentages permettent d'améliorer la stabilité du dispositif organique électronique, et sans augmenter les résistances séries au sein du dispositif ou les défauts qui sont assimilables à des zones de recombinaison.

Avantageusement, le polyéthylènimine est un polyéthylènimine éthoxylé.

Avantageusement, le matériau accepteur d'électrons est un polymère de type N ou un dérivé soluble de fullerène, tel que le [6,6]-phényl-C₆₁-butyrate de méthyle, et le matériau donneur d'électrons est choisi parmi le poly(3-hexyl)thiophène (P3HT), le poly[N-9'-heptadécanyl-2,7-carbazole-alt-5,5-(4,7-di-2-thiényl-2',1',3'-benzothiadiazole] (PCDTBT), le poly[[4,8-bis[(2-éthylhexyl)oxy]benzo[1,2- b:4,5-b']dithiophène-2,6-diyl][3-fluoro-2-[(2-éthylhexyl)carbonyl]thiéno[3,4-b]thiophènediyl]] (PTB7), le Poly([2,6'-4,8-di(5-éthylhexylthiényl)benzo[1,2-b;3,3-b]dithiophène]{3-fluoro-2[(2-éthylhexyl)carbonyl]thiéno[3,4-b]thiophènediyl})(PTB7-Th).

Avantageusement, la couche active a une épaisseur allant de 100nm à 500nm.

Avantageusement, la couche de type N est en oxyde métallique, de préférence en ZnO, éventuellement dopé.

Avantageusement, la couche de type N a une épaisseur allant de 5nm à 95nm, et de préférence de 40nm à 50nm. De telles couches sont faciles à déposer par rapport à des couches de faibles épaisseurs (inférieure à 5nm). Il y a moins de risque de former une couche discontinue.

Avantageusement, le substrat est en verre, ou en polymère, par exemple choisi parmi le poly(téréphtalate d'éthylène), le polynaphtalate d'éthylène, et les copolymères cyclo oléfiniques. L'utilisation de ces matériaux permet de réaliser des substrats flexibles. Par flexible, on entend que le substrat peut être conformable, c'est-à-dire qu'il peut être courbé sans être détérioré.

Avantageusement, le dispositif électronique organique est une diode électroluminescente organique, un photodétecteur organique, ou une cellule photovoltaïque organique.

Avantageusement, le dispositif a une architecture tandem, c'est-à-dire que le dispositif comprend deux sous-ensemble, chacun ayant une structure inverse, empilés l'un sur l'autre selon le schéma NIP/NIP.

L'invention concerne également un procédé de fabrication d'un dispositif électronique organique ou hybride ne nécessitant pas de déposer une fine couche de PEI, facile à mettre et transposable à grande échelle.

Ce but est atteint par un procédé de fabrication d'un dispositif électronique organique ou hybride, à structure NIP, selon la revendication 11.

Le procédé ne nécessite pas d'utiliser des solvants chlorés et peut être facilement industrialisé. Il permet de fabriquer des dispositifs électroniques organiques flexibles avec une durée de vie améliorée sans avoir besoin de réaliser une étape de dépôt d'une fine couche de PEI qui est difficile à maîtriser.

Avantageusement, le dépôt de la couche active est réalisé par dépôt à la tournette, par impression ou par enduction.

### BRÈVE DESCRIPTION DES DESSINS

D'autres caractéristiques et avantages de l'invention ressortiront mieux de la description qui va suivre et des dessins annexés dans lesquels :
- les figures 1A, 1B et 1C, précédemment décrites, représentent des vues partielles, en coupe et de profil, de cellules photovoltaïques organiques, selon l'art antérieur,
- la figure 2 représente une vue partielle, en coupe et de profil, d'une cellule photovoltaïque organique selon un premier mode de réalisation particulier de l'invention,
- la figure 3 représente une vue partielle, en coupe et de profil, d'une cellule photovoltaïque organique selon un deuxième mode de réalisation particulier de l'invention,
- la figure 4 représente l'évolution du rendement de conversion sous illumination continue de différentes cellules photovoltaïques organiques selon différents modes de réalisation de l'invention, ainsi que d'une cellule photovoltaïque organique sans PEI et d'une cellule photovoltaïque organique ayant un bicouche ZnO/PEI,
- la figure 5 représente l'évolution du rendement de conversion sous illumination continue de différentes cellules photovoltaïques organiques selon différents modes de réalisation de l'invention, ainsi que d'une cellule photovoltaïque organique de référence sans PEI.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Par la suite, on décrira l'invention pour une cellule photovoltaïque, organique ou hybride, à structure NIP. L'homme du métier pourra transposer cet enseignement pour tout autre dispositif électronique organique tel qu'une diode électroluminescente organique (OLED), un photodétecteur organique (OPD). Ces dispositifs électroniques peuvent présenter une architecture tandem.

On se réfère tout d'abord à la figure 2 qui représente une cellule photovoltaïque à structure NIP. La cellule comprend successivement, et de préférence est constituée par :
- un substrat 100 transparent,
- une première électrode 101 transparente et électriquement conductrice,
- une couche de type N 102,
- une couche active 103 comprenant soit un matériau donneur d'électrons et un matériau accepteur d'électrons et un polyéthylènimine 200 soit un matériau pérovskite et un polyéthylèneimine 200,
- une couche de type P 104,
- une seconde électrode 105 électriquement conductrice.

Le substrat 100 est, de préférence, flexible.

Le substrat 100 est, par exemple, en verre, ou en polymère, par exemple choisi parmi le poly(téréphtalate d'éthylène) (PET), le polynaphtalate d'éthylène (PEN), et les copolymères cyclo oléfiniques (CCO ou COC pour « Cyclic Olefin Copolymer »).

Le substrat 100 comporte deux faces principales parallèles l'une par rapport à l'autre. Par parallèle, on entend parallèle ou sensiblement parallèle.

Une des faces principales est destinée à recevoir les rayons lumineux (représentés par des flèches), il s'agit de la face avant. La face avant n'est pas texturée sur les figures. Cependant, pour mieux piéger la lumière, la face avant pourrait être texturée.

La face avant du substrat 100 est recouverte par la première électrode 101.

La première électrode 101, aussi appelée électrode inférieure, est disposée entre le substrat et la couche active. Elle doit être transparente, de manière à laisser passer les photons jusqu'à la couche active, et électriquement conductrice. Elle peut être en oxyde transparent conducteur (OTC) ou en un matériau semi-conducteur. Cette électrode peut être en oxyde d'indium-étain (ITO), en oxyde de zinc, en oxyde de zinc dopé à l'aluminium aussi appelé AZO (ZnO :Al), ou encore elle peut être formée d'un polymère transparent conducteur comprenant des nanofils d'argent par exemple.

La première électrode 101 est électriquement connectée à la couche de type N.

La couche de type N 102, aussi appelée couche d'injection des électrons (EIL), peut être en oxyde métallique, natif ou dopé. Elle est, par exemple, en oxyde de zinc (ZnO), en oxyde de zinc dopé à l'aluminium (ZnO :Al), en oxyde de titane (TiO₂) ou en oxyde d'étain (SnO₂).

La couche de type N 102 a une épaisseur allant de 5nm à 95nm, et de préférence allant de 40nm à 50nm.

La cellule est dépourvue de couche mince de PEI à l'interface couche active/couche de type N.

La couche active 103 absorbe les photons et génère les charges libres. Elle a une épaisseur allant, par exemple, de 100nm à 500nm.

La couche active 103 est une hétérojonction en volume comprenant un matériau donneur d'électrons et un matériau accepteur d'électrons.

Le matériau donneur d'électrons est un matériau de type P, par exemple un polymère de type P. Parmi les polymères donneurs d'électrons, on peut citer par exemple le poly(3-hexyl)thiophène (P3HT), le poly[2-méthoxy-5-(3,7-diméthyloctyloxy)-1,4-phénylène-vinylène] (MDMO-PPV), ou le poly[N-9'-heptadécanyl-2,7-carbazole-alt-5,5-(4,7-di-2-thiényl-2',1',3'-benzothiadiazole] (PCDTBT) et le PBTZT-stat-BDTT-8 (aussi connu sous le nom de PV-D4610, commercialisé par la société Merck). Parmi les familles de polymère actif, on peut également citer la famille des PTB7, incluant le PTB7-Th, ou encore les familles des PBDTBDD, des PDBT-T1, des PPDT2FBT, des PffBT4T2OD, et des DT-PDPP2T-TT.

Le matériau accepteur est un matériau de type N, par exemple, un polymère de type N, du graphène, des nanotubes de carbone semi-conducteur, du fullerène ou un mélange de fullerènes (C₆₀, et/ou C₇₀ et/ou C₈₄), ou encore un dérivé soluble de fullerène tel que le [6,6]-phényl-C₆₁-butyrate de méthyle (PCBM).

Lorsqu'il s'agit d'une cellule photovoltaïque hybride, la couche active comporte un matériau pérovskite jouant le rôle d'hétérojonction en volume.

La couche active à base de pérovskite comprend avantageusement au moins un matériau pérovskite hybride organique-inorganique. De manière avantageuse, la pérovskite est un matériau comportant 1, 2 ou 3 cations et des anions, par exemple des halogènes, notamment Cl, Br, I, et leurs mélanges.

La pérovskite est avantageusement de type ABX₃ (A et B représentant deux cations différents, et X représentant trois halogènes) dans laquelle :
- A représente avantageusement au moins un ion organo-ammonium, par exemple de type méthylammonium (MA) ou bien formamidinium (FA) ou bien un mélange des deux, éventuellement associé à du césium et/ou du rubidium,
- B représente avantageusement le plomb, l'étain, le bismuth ou l'antimoine,
- X est avantageusement choisi parmi : Cl, Br, I ou une combinaison de ces halogénures.

Par exemple, la pérovskite peut être de type MAPbl₃, ou MAFAPbl₃ ou MAFACsPbl₃. Il peut également s'agir de MAPbl₃₋ₓClₓ avec x compris entre 0 et 10 ou de MAPbl₃₋ₓBrₓ avec x compris entre 0 et 100.

La pérovskite peut être de type bidimensionnel ou tridimensionnel.

La couche active à base de pérovskite présente une épaisseur avantageusement comprise entre 50 nanomètres et 1000 nanomètres, plus avantageusement entre 200 nanomètres et 500 nanomètres.

La couche active 103 comprend, en plus, un polyéthylènimine (PEI) 200. D'une manière générale, le PEI peut avoir une masse molaire moyenne en nombre Mn allant de 500 à 20000g/mol, par exemple de 500 à 10000g/mol.

Le PEI 200 peut être linéaire, branché ou ramifié.

Le PEI 200 branché comprend des amines secondaires. Le PEI branché peut avoir une masse molaire moyenne en nombre Mn variant de 500 à 5000g/mol, de préférence de 1000 à 2000g/mol, et encore plus préférentiellement de 1200g/mol à 1800g/mol. La masse molaire moyenne en nombre Mn représente la moyenne des masses molaires pondérée par le nombre de chaînes de chaque longueur.

Le PEI peut autrement être défini par la masse molaire moyenne en masse Mw qui correspond à la moyenne des masses molaires pondérée par la masse de chaînes de chaque longueur. Par exemple, une masse molaire moyenne en nombre Mn allant de 1200g/mol à 1800g/mol correspond à une masse molaire moyenne en masse Mw allant de 1300g/mol à 2000g/mol respectivement.

Le PEI 200 ramifié comprend des amines primaires, secondaires et tertiaires. Le PEI ramifié peut avoir une masse molaire moyenne de l'ordre de 10000g/mol, correspondant à une masse molaire moyenne en poids de 25000g/mol.

Selon un mode de réalisation particulier, le PEI 200 peut être un polyéthylènimine éthoxylé (PEIE).

On suppose une ségrégation verticale du PEI 200 dans la couche active 113 avec un gradient de concentration en PEI 200 qui va en augmentant vers l'interface couche active 113/couche de type N 102.

La couche de type P 104, aussi appelée couche de transport des trous (HTL), est en un matériau de type P. Il s'agit, par exemple, du Poly(3,4-éthylènedioxythiophène) polystyrène sulfonate (PEDOT:PSS) ou d'un oxyde métallique tel qu'un oxyde de molybdène, un oxyde de vanadium ou un oxyde de tungstène.

La couche de type P 104 est électriquement connectée à la seconde électrode 105.

Comme la seconde électrode 105, aussi appelée électrode supérieure, est positionnée en face arrière, derrière la couche active 103, par rapport au rayonnement, elle peut être opaque ou de transparence limitée, par exemple, en métal. Elle est, par exemple, en argent, en or, en chrome, en aluminium ou en un mélange de ces métaux.

Comme représenté sur la figure 3, dans le cas d'une cellule photovoltaïque organique à structure inverse et à architecture tandem (NIP/NIP), la cellule selon l'invention comprend successivement et, de préférence, est constituée par :
- un substrat 100 transparent,
- une première électrode 101 transparente et électriquement conductrice,
- une première couche de type N 102,
- une première couche active 103 comprenant : un matériau donneur d'électrons, un matériau accepteur d'électrons et un polyéthylènimine 200,
- une première couche de type P 104,
- une seconde couche de type N 112,
- une seconde couche active 113 comprenant : un matériau donneur d'électrons, un matériau accepteur d'électrons et un polyéthylènimine 200,
- une seconde couche de type P 114,
- une seconde électrode 105 électriquement conductrice.

Les matériaux utilisés pour réaliser la cellule photovoltaïque à architecture tandem peuvent être les mêmes que dans le cas d'une cellule photovoltaïque à structure inverse simple, telle que précédemment décrite.

La première couche active 103 et la seconde couche active 113 peuvent avoir la même composition ou des compositions différentes. Elles peuvent avoir la même épaisseur ou des épaisseurs différentes. Le PEI de la première couche active 103 peut être identique ou différent de celui de la seconde couche active 113.

Il en va de même pour la première couche de type N 102 et la seconde couche de type N 112.

Il en va également de même pour la première couche de type P 104 et la seconde couche de type P 114.

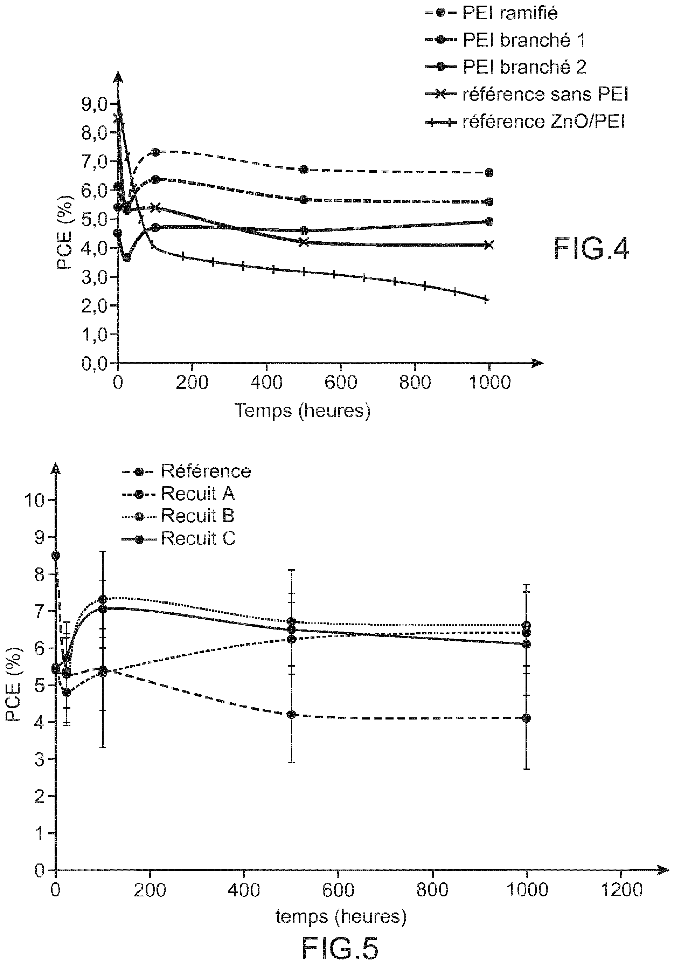

Les rendements de conversion de différentes cellules OPV à structure inverse simple, comme représentée sur la figure 2, ont été mesurés. La couche active 103 des cellules OPV contient du PV-D4610 commercialisé par Merck, du PCBM et 0,01% de PEI par rapport au poids de polymère donneur dans un mélange binaire de solvants non chlorés. La couche de type N 102 est en ZnO. Trois PEI ont été étudiés : deux PEI faiblement branchés de masse molaire Mn 1200g/mol (noté 'PEI branché 1' sur la figure 4) et 1800g/mol (noté 'PEI branché 2') et un PEI fortement branché de masse molaire Mn 10000g/mol (noté 'PEI ramifié').

L'évolution du rendement de conversion des cellules OPV (surface active = 0,1256 cm²) est représentée figure 4. Les conditions expérimentales sont les suivantes : illumination continue AM1.5, puissance de 1000W/m², température de 40°C.

Les cellules ont été comparées avec une cellule de référence qui comporte une couche de ZnO et une couche active sans PEI (noté 'référence sans PEI' sur la figure 4) et une cellule qui comporte un bicouche ZnO/PEI et une couche active sans PEI (noté 'référence ZnO/PEI'). Pour ces cellules de référence, le PEI est un PEI ramifié. Le PEI représente 0,01% en poids par rapport au poids du polymère donneur de la couche active.

Pour toutes les conditions de mise en œuvre testées, les performances initiales des cellules de l'invention sont plus faibles que celles des cellules de référence, mais elles ne présentent pas de dégradation initiale importante contrairement aux cellules de référence. Pour les cellules de l'invention, les rendements photovoltaïques augmentent et atteignent un plateau au-delà de 6% en moyenne (maximum à 7,5%). Ceci représente une amélioration de 2% absolu après 1000h sous illumination continue par rapport à la cellule de référence sans PEI.

Les résultats avec la cellule selon l'invention sont également supérieurs par rapport à une cellule ayant un bi-couche ZnO/PEI. Le gradient de concentration dans la couche active est favorable à la stabilité par rapport à une couche bien définie du même matériau à l'interface ZnO/couche active.

Les rendements de conversion de cellules OPV avec une couche de type N formée d'un mélange PEI/ZnO ont également été mesurés. Les rendements et la stabilité intrinsèque des cellules de l'invention est meilleure.

L'ajout de PEI, branché ou ramifié, dans la couche active d'un dispositif OPV ayant également une couche de type N, améliore la stabilité du dispositif par rapport aux dispositifs de référence.

L'invention concerne, en outre, un procédé de réalisation d'une cellule photovoltaïque organique ou hybride comportant au moins les étapes successives suivantes :
a) fourniture d'un substrat 100 transparent recouvert, successivement, par une première électrode 101 transparente et électriquement conductrice, et par une couche de type N 102,
b) formation d'une couche active 103 par voie humide, par dépôt d'une solution contenant un polyéthylènimine 200 et un solvant non chloré, et soit un matériau donneur d'électrons et un matériau accepteur d'électrons, soit un matériau pérovskite, puis recuit,
c) dépôt d'une couche de type P 104,
d) dépôt d'une seconde électrode 105 électriquement conductrice.

Par solvant non chloré, on entend un solvant non chloré ou un mélange de plusieurs solvants non chlorés. Le solvant non chloré est, par exemple, choisi parmi le o-xylène, le 1-méthylnaphthalène, la tétraline, et la mésitylène, ou un de leurs mélanges. Le choix du solvant sera fait en fonction du ou des matériaux formant la couche active afin de permettre une bonne solubilisation du ou de ces matériaux.

La solution déposée à l'étape b) peut être préparée en mélangeant :
- une première solution comprenant un solvant non chloré et soit le matériau donneur et le matériau accepteur soit le matériau pérovskite, et
- une seconde solution comprenant le PEI, éventuellement hydraté, et un solvant non chloré.

Le dépôt de la couche de type N 102 et/ou de la couche active 103 et/ou de la couche de type P 104 peut être réalisé à température ambiante ou à température modérée. Par température ambiante, on entend une température de 20-25°C, et par température modérée, on entend une température supérieure à 25°C et pouvant aller jusqu'à 70°C.

Le dépôt de la couche active 103 et/ou de la couche de type N 102 et/ou de la couche de type P 104 peut être effectués par voie humide. Il peut être, par exemple, réalisé par toute technique d'impression et/ou d'enduction tel que le dépôt par jet d'encre, par sérigraphie, par passage à travers une fente (« slot-die »), par pulvérisation (« spray coating »), avec une lame (« doctor blade »), ou encore par dépôt à la tournette, aussi appelé dépôt par centrifugation (« spin coating »).

L'empilement peut être soumis à une ou plusieurs étapes de recuit. Par exemple, il peut s'agir d'un recuit réalisé après l'étape b) ou c) ou de plusieurs recuits réalisés après chaque dépôt de couche par voie humide. La réalisation d'un recuit après chaque dépôt de couche par voie humide permet un meilleur séchage des différentes couches et/ou une microségrégation de phases dans le cas de la couche active. L'étape de recuit favorise la formation du gradient de concentration en PEI dans la couche active. On pourra, avantageusement, réaliser une étape de recuit de ces différentes couches.

L'étape de recuit peut être réalisée de plusieurs façons :
- un recuit rapide directement à une température de consigne relativement élevée mais avantageusement inférieure à 150°C et, de préférence, aux environs de 120°C,
- un recuit en plusieurs phases : une phase de séchage qui peut être à l'air ou à température modérée (par exemple 50°C) et une phase de recuit à une température plus élevée mais, avantageusement, inférieure à 150°C et, de préférence, aux environs de 120°C.

Le recuit permet d'évaporer le solvant mais il a également un impact sur la morphologie de la couche active.

Dans le cas des dispositifs organiques, il permet d'obtenir une bonne ségrégation de phase entre les matériaux formant la couche active.

Dans le cas des dispositifs hybrides, la cristallisation du matériau pérovskite est améliorée, notamment en jouant sur la taille des cristaux.

La température du traitement thermique pour sécher la couche active va, par exemple, de 80°C à 160°C, selon la nature du polymère. Par exemple, pour une couche active 103 de P3HT :PCBM, la température du recuit est de 100-150°C. La durée du recuit peut être de quelques minutes, par exemple de l'ordre de 2 minutes.

Pour une architecture de type tandem, le procédé précédemment décrit comprend, entre l'étape c) et l'étape d), les dépôts successifs d'une seconde couche de type N 112, d'une seconde couche active 113 et d'une seconde couche de type P 114.

Ce procédé est particulièrement intéressant pour les cellules solaires OPV fabriquées par des procédés feuille à feuille ou au déroulé, par des techniques par impression jet d'encre ou par enduction, où la limitation du nombre d'étapes de dépôt est cruciale et la maitrise de couches d'épaisseurs très faible est critique, et pour lesquelles la durée de vie est primordiale.

Avantageusement, le procédé peut comporter une étape ultérieure dans laquelle la cellule photovoltaïque est encapsulée pour être protégée des éléments extérieurs, en particulier de l'air (vapeur d'eau et dioxygène).

La mise en œuvre de l'encapsulation est réalisée en positionnant les cellules entre deux couches de matériaux dits « barrières aux gaz » ou en protégeant uniquement sur la face avant. Les matériaux barrières aux gaz sont classiquement des couches denses (par exemple des plaques de verre ou de métal) ou des films multicouches associant de fines couches inorganiques denses placées entre des couches organiques. Le film barrière ou la couche d'isolation rigide (verre ou métal) peut être maintenu sur la cellule photovoltaïque grâce à un adhésif sensible à la pression, à une colle liquide ou à un polymère thermoplastique mis en œuvre par laminage sous vide par exemple. Un exemple de polymère thermoplastique est un film en copolymère éthylène/acétate de vinyle EVA. Ce film encapsulant a une épaisseur comprise, typiquement, entre 50 µm et 500 µm.

Les techniques d'encapsulation étant bien connues de l'homme du métier, elles ne seront pas détaillées ici.

### Exemple illustratif et non limitatif d'un procédé de fabrication d'un dispositif cellule photovoltaïque organique :

De manière illustrative et non limitative, une cellule photovoltaïque de type NIP peut être réalisée selon les étapes suivantes :
- formation d'une première électrode 101 en TCO sur un substrat 100 en PET de 180µm d'épaisseur,
- formation d'une couche de type N 102, par exemple en ZnO d'environ 50nm épaisseur, par voie humide sur l'électrode supérieure 110, suivi d'un recuit à 120°C,
- formation d'une couche active 103, en déposant une solution contenant du PV-D4610 et du PCBM formulés dans un mélange de solvants non chlorés et comprenant un PEI 200 linéaire ou ramifié, la couche active 103 ayant une épaisseur de 300 nm sur la couche de type N, suivi d'un recuit à 50°C, et d'un recuit à 120°C,
- formation d'une couche de type P 104, en HTL de type PEDOT :PSS, d'une épaisseur de 80 nm, puis recuit à 100°C,
- formation d'une seconde électrode 105,
- encapsulation, par exemple par lamination d'un film barrière aux gaz et d'un encapsulant en face avant.

La figure 5 représente l'évolution du rendement de conversion pour différents recuits. Le recuit A correspond à un recuit de 2min à 120°C. Le recuit B correspond à un séchage libre suivi d'un recuit de 2min à 120°C. Le recuit C correspond à un recuit de 2min à 50°C suivi d'un recuit de 2min à 120°C. La façon de sécher la couche active a peu d'impact sur le rendement de conversion.

## Revendications

1. Dispositif électronique organique ou hybride, à structure NIP, comprenant successivement :
- un substrat (100) transparent,
- une première électrode (101) transparente et électriquement conductrice,
- une couche de type N (102),
- une couche active (103) comprenant un polyéthylènimine (PEI) (200) et :
∘ un matériau donneur d'électrons et un matériau accepteur d'électrons,
∘ ou un matériau pérovskite,
- une couche de type P (104),
- une seconde électrode (105), **caractérisé en ce que** la couche active a un gradient de concentration en PEI (200) qui va en augmentant vers l'interface de la couche active (103)/ couche de type N (102).

2. Dispositif électronique selon la revendication 1, **caractérisé en ce que** le polyéthylèneimine (200) représente de 0,005% à 0,5%, et de préférence de 0,01% à 0,1% massique par rapport au matériau donneur d'électrons ou par rapport au matériau pérovskite de la couche active (103).

3. Dispositif électronique selon l'une des revendications 1 et 2, **caractérisé en ce que** le polyéthylènimine (200) est un polyéthylènimine éthoxylé.

4. Dispositif électronique selon l'une quelconque des revendications précédentes, **caractérisé en ce que** le matériau accepteur d'électrons est un polymère de type N ou un dérivé soluble de fullerène, tel que le [6,6]-phényl-C₆₁-butyrate de méthyle, et **en ce que** le matériau donneur d'électrons est choisi parmi le poly(3-hexyl)thiophène, le poly[N-9'-heptadécanyl-2,7-carbazole-alt-5,5-(4,7-di-2-thiényl-2',1',3'-benzothiadiazole], le poly[[4,8-bis[(2-éthylhexyl)oxy]benzo[1,2-b:4,5-b']dithiophène-2,6-diyl][3-fluoro-2-[(2-éthylhexyl)carbonyl]thiéno[3,4-b]thiophènediyl]], et le Poly([2,6'-4,8-di(5-éthylhexylthiényl)benzo[1,2-b;3,3-b]dithiophène]{3-fluoro-2[(2-éthylhexyl)carbonyl] thiéno[3,4-b]thiophènediyl}).

5. Dispositif électronique selon l'une quelconque des revendications précédentes, **caractérisé en ce que** la couche active (103) a une épaisseur allant de 100nm à 500nm.

6. Dispositif électronique selon l'une quelconque des revendications précédentes, **caractérisé en ce que** la couche de type N (102) est en oxyde métallique, de préférence en ZnO, éventuellement dopé.

7. Dispositif électronique selon l'une quelconque des revendications précédentes, **caractérisé en ce que** la couche de type N (102) a une épaisseur allant de 5nm à 95nm, et de préférence de 40nm à 50nm.

8. Dispositif électronique selon l'une quelconque des revendications précédentes, **caractérisé en ce que** le substrat (100) est en verre, ou en polymère, par exemple choisi parmi le poly(téréphtalate d'éthylène), le polynaphtalate d'éthylène, et les copolymères cyclo oléfiniques.

9. Dispositif électronique selon l'une quelconque des revendications précédentes, **caractérisé en ce que** le dispositif électronique organique est une diode électroluminescente organique, un photodétecteur organique, ou une cellule photovoltaïque organique.

10. Dispositif électronique selon l'une quelconque des revendications précédentes, **caractérisé en ce que** le dispositif a une architecture tandem.

11. Procédé de fabrication d'un dispositif électronique organique ou hybride, à structure NIP selon une des revendications précédentes, comportant au moins les étapes successives suivantes :
a) fourniture d'un substrat (100) transparent recouvert, successivement, par une première électrode (101) transparente et électriquement conductrice, et par une couche de type N (102),
b) formation d'une couche active (103) par dépôt d'une solution contenant un polyéthylènimine (200), un solvant non chloré, et, un matériau donneur d'électrons et un matériau accepteur d'électrons, ou un matériau pérovskite, puis recuit.

12. Procédé selon la revendication 11, **caractérisé en ce que** le dépôt de la couche active (103) est réalisé par dépôt à la tournette, par impression ou par enduction.

## Patentansprüche

1. Organische oder hybride elektronische Vorrichtung mit pin-Struktur, die nacheinander enthält:
- ein transparentes Substrat (100),
- eine erste transparente und elektrisch leitende Elektrode (101),
- eine Schicht vom n-Typ (102),
- eine aktive Schicht (103), die ein Polyethylenimin (PEI) (200) enthält sowie
∘ ein Elektronendonormaterial und ein Elektronenakzeptormaterial,
∘ oder ein Perowskit-Material,
- eine Schicht vom p-Typ (104),
- eine zweite Elektrode (105),
**dadurch gekennzeichnet, dass**
die aktive Schicht einen Gradienten der PEI-Konzentration (200) aufweist, der zur Grenzfläche zwischen aktiver Schicht (103) und Schicht vom n-Typ (102) hin zunimmt.

2. Elektronische Vorrichtung nach Anspruch 1,
**dadurch gekennzeichnet, dass**
das Polyethylenimin (200) 0,005 % bis 0,5 %, vorzugsweise 0,01 % bis 0,1 Masse-%, bezogen auf das Elektronendonormaterial oder auf das Perowskit-Material der aktiven Schicht (103), ausmacht.

3. Elektronische Vorrichtung nach einem der Ansprüche 1 und 2,
**dadurch gekennzeichnet, dass**
das Polyethylenimin (200) ein ethoxyliertes Polyethylenimin ist.

4. Elektronische Vorrichtung nach einem der vorangehenden Ansprüche,
**dadurch gekennzeichnet, dass**
das Elektronenakzeptormaterial ein Polymer vom n-Typ oder ein lösliches Fullerenderivat ist, wie etwa Methyl[6,6]-Phenyl-C₆₁-butyrat, und dass das Elektronendonormaterial ausgewählt ist aus Poly(3-hexyl)thiophen, Poly[N-9'-heptadecanyl-2,7-carbzol-alt-5,5-(4,7-di-2-thienyl-2',1',3'-benzothiadiazol], Poly[[4,8-bis(2-ethylhexyl)oxy]benzo[1,2-b:4,5-b']Dithiophen-2,6-diyl][3-Fluor-2-[(2-ethylhexyl)carbonyl]thieno[3,4-b]thiophendiyl)] und Poly([2,6'-4,8-di(5-ethylhexylthienyl)benzol[1,2-b;3,3-b]dithiophen]{3-Fluor-2[(2-ethylhexl)carbonyl]thieno[3,4-b]thiophendiyl}).

5. Elektronische Vorrichtung nach einem der vorangehenden Ansprüche,
**dadurch gekennzeichnet, dass**
die aktive Schicht (103) eine Dicke von 100 nm bis 500 nm hat.

6. Elektronische Vorrichtung nach einem der vorangehenden Ansprüche,
**dadurch gekennzeichnet, dass**
die Schicht vom n-Typ (102) ein gegebenenfalls dotiertes Metalloxid, vorzugsweise ZnO ist.

7. Elektronische Vorrichtung nach einem der vorangehenden Ansprüche,
**dadurch gekennzeichnet, dass**
die Schicht vom n-Typ (102) eine Dicke von 5 nm bis 95 nm, vorzugsweise von 40 nm bis 50 nm hat.

8. Elektronische Vorrichtung nach einem der vorangehenden Ansprüche,
**dadurch gekennzeichnet, dass**
das Substrat (100) aus Glas oder Polymer besteht, beispielsweise ausgewählt aus Polyethylenterephatlat, Polyethylennaphthalat und Cycloolefin-Copolymeren.

9. Elektronische Vorrichtung nach einem der vorangehenden Ansprüche,
**dadurch gekennzeichnet, dass**
die organische elektronische Vorrichtung eine organische lichtemittierende Diode, ein organischer Photodetektor oder eine organische photovoltaische Zelle ist.

10. Elektronische Vorrichtung nach einem der vorangehenden Ansprüche,
**dadurch gekennzeichnet, dass**
die Vorrichtung eine Tandem-Architektur hat.

11. Verfahren zum Herstellen einer organischen oder hybriden elektronischen Vorrichtung mit pin-Struktur nach einem der vorangehenden Ansprüche, umfassend zumindest die nachstehenden, aufeinanderfolgenden Schritte:
a) Bereitstellen eines transparenten Substrats (100), das nacheinander mit einer ersten transparenten, elektrisch leitenden Elektrode (101) und einer Schicht vom n-Typ (102) bedeckt ist,
b) Ausbilden einer aktiven Schicht (103) durch Abscheiden einer Lösung, enthaltend ein Polyethylenimin (200), ein nicht-chloriertes Lösungsmittel und ein Elektronendonormaterial und ein Elektronenakzeptormaterial oder ein Perowskit-Material, dann Glühen.

12. Verfahren nach Anspruch 11,
**dadurch gekennzeichnet, dass** die Abscheidung der aktiven Schicht (103) durch Spin-Coating, Bedrucken oder Beschichten erfolgt.

## Claims

1. Organic or hybrid electronic device, having an NIP structure, comprising successively:
- a transparent substrate (100),
- a first transparent and electrically conducting electrode (101)
- an N type layer (102),
- an active layer (103) comprising a polyethylenimine (PEI) (200) and:
∘ an electron donor material and an electron acceptor material,
∘ or a perovskite material,
- a P type layer (104),
- a second electrode (105), **characterized in that** the active layer has a concentration gradient of PEI (200) that increases towards the interface of the active layer (103)/N type layer (102).

2. Electronic device according to claim 1, **characterised in that** polyethyleneimine (200) represents from 0.005% to 0.5%, and preferably from 0.01% to 0.1% by mass with respect to the electron donor material or with respect to the perovskite material of the active layer (103).

3. Electronic device according to one of claims 1 and 2, **characterised in that** the polyethylenimine (200) is an ethoxylated polyethylenimine.

4. Electronic device according to any one of the preceding claims, **characterised in that** the electron acceptor material is N type polymer or a soluble fullerene derivative, such as [6,6]-phenyl-C₆₁-butyric acid methyl ester, and the electron donor material is chosen from poly(3-hexyl)thiophene, poly[N-9'-heptadecanyl-2,7-carbazole-alt-5,5-(4,7-di-2-thienyl-2',1',3'-benzothiadiazole], poly[[4,8-bis[(2-ethylhexyl)oxy] benzo [1,2-b:4,5-b']dithiophene-2,6-diyl][3-fluoro-2-[(2-ethylhexyl)carbonyl]thieno[3,4-b]thiophenediyl]], and Poly([2,6'-4,8-di(5-ethylhexylthienyl)benzo[1,2-b;3,3-b]dithiophene]{3-fluoro-2[(2-ethylhexyl)carbonyl]thieno[3,4-b]thiophenediyl}).

5. Electronic device according to any one of the preceding claims, **characterised in that** the active layer (103) has a thickness ranging from 100nm to 500nm.

6. Electronic device according to any one of the preceding claims, **characterised in that** the N type layer (102) is made of metal oxide, preferably of ZnO, optionally doped.

7. Electronic device according to any one of the preceding claims, **characterised in that** the N type layer (102) has a thickness ranging from 5nm to 95nm, and preferably from 40nm to 50nm.

8. Electronic device according to any one of the preceding claims, **characterised in that** the substrate (100) is made of glass, or of polymer, for example chosen from poly(ethylene terephthalate), polyethylene naphthalate, and cyclic olefin copolymers.

9. Electronic device according to any one of the preceding claims, **characterised in that** the organic electronic device is an organic light-emitting diode, an organic photodetector, or an organic photovoltaic cell.

10. Electronic device according to any one of the preceding claims, **characterised in that** the device has a tandem architecture.

11. Method for manufacturing an organic or hybrid electronic device, having an NIP structure according to one of the preceding claims, including at least the following successive steps:
a) providing a transparent substrate (100) coated, successively with a first transparent and electrically conducting electrode (101), and with an N type layer (102),
b) forming an active layer (103) by deposition of a solution containing a polyethylenimine (200), a non-chlorinated solvent, and, an electron donor material and an electron acceptor material, or a perovskite material, followed by annealing.

12. Method according to claim 11, **characterised in that** the deposition of the active layer (103) is carried out by spin-coating, by printing or by coating.
